# EUROPEAN PATENT APPLICATION

(11) **EP 1 014 591 A2**
(43) Date of publication of application: **28.06.2000**
(21) Application number: 99309333.5
(22) Date of filing: 23.11.1999
(51) Int. Cl.: H04B 1/04, H03F 1/32

(54) **Linearizing circuit for a transmitter**

(30) Priority: 23.12.1998 GB 9828539
(71) Applicant: NOKIA MOBILE PHONES LTD., 02150 Espoo (FI)
(72) Inventor: Brett, Sean, Camberley, Surrey GU16 5TP (GB); Saunders, Robert, Irvine, CA 92606 (US)
(74) Representative: Jeffery, Kendra Louise

(57) **Abstract**

A transmitter for a radio communications device is disclosed. The transmitter comprises a conventional transmitter path (10), a feedback path (20) and control means (40). The feedback path feeds back the signal amplified, and the control means provides adaptive distortion of the signal transmitted on the basis of this fedback signal.

## Description

The present invention relates to a radio transmitter. In particular it relates to the transmitter architecture for a mobile communication device.

A general trend in portable communication apparatus is the improvement of the efficiency of such apparatus. One component which particularly affects the efficiency of a device is the high current consuming power amplifier of its transmitter. Efficiency of power amplifiers can be improved by designing them to be non-linear. However, the use of non-linear power amplifiers is not without certain drawbacks. These vary depending on the telecommunication system in which the power amplifier is to be employed.

In theory, non-linear power amplifiers can be used in devices for telecommunication systems which use modulation schemes providing constant amplitude (for example GSM, which uses GMSK) without distorting the signal. However, in practice, distortion by the power amplifier in a GSM transmitter may cause a variation in amplitude envelope and thus a variation in power efficiency.

In contrast, devices for use in telecommunication systems which use amplitude modulation schemes (for example CDMA and JDC which use QPSK) require a linear power amplifier to avoid distortion and are thus inherently more power inefficient.

According to the present invention, there is provided a transmitter for a radiotelephone, comprising a power amplifier in its transmission path for amplifying a signal to be transmitted; a feedback path from the power amplifier output to the transmission path input; demodulator for down-converting and demodulating the signal output by the power amplifier in the feedback path; and means for adjusting the signal to be applied to the transmitter input in response to the demodulator output.

Such a transmitter provides adaptive pre-distortion to compensate for distortion/non-linearities incurred by the power amplifier. Consequently, it enables a non-linear power amplifier to be used in amplitude modulation based systems such as JDC, WCDMA, thus providing improved power efficiency. This in turn results in improved talk and standby time for a communication device employing such a transmitter.

Also, it enables a lower specification amplifier to that conventionally required to obtain a required efficiency level.

The demodulator of the invention employs direct down conversion. This provides the advantage of eliminating the need for multiple mixer and demodulator stages in the feedback path, thereby reducing the transmitter feedback path complexity and cost.

In a preferred embodiment the demodulator comprises the mixer having an input coupled to an up-converting frequency source (e.g. UHF), an input coupled to a modulating source (e.g. VHF) and an output for providing the demodulating signal (e.g. IF). In order to reduce the number of components required, the mixer inputs may be coupled to the transmitter's up-converting frequency source and modulating source.

Any DC offsets introduced on to the modulating signal, due to the direct conversion process for example, may be compensated for by means of a DC offset compensator. This may be provided by way of simple circuitry such as one or more operational amplifiers and a low-pass filter.

The demodulator may comprise means for periodically presenting a demodulated signal to the adjusting means. Such means may be switching means for opening and closing the transmitter feedback path. Provision of such switching means is particularly advantageous when AD converters are provided in the feedback path of the transmitter, and the switching means is used to switch the AD converters on and off, since this reduces their power consumption.

According to another aspect, there is provided a transceiver having a transmitter of the present invention and a receiver. Preferably the transmitter feedback path is at least partially provided by the receiver circuitry as this reduces the number of components required, and in turn reduces the size and power consumption of such a transceiver.

According to a further aspect of the present invention, there is provided a radio telephone comprising such a transmitter or transceiver.

Embodiments of the present invention will now be described, by way of example, with reference to the accompanying drawings, of which:
Figure 1 is a block diagram of a transmitter according to a preferred embodiment of the present invention;
Figure 2 is a transmitter according to an embodiment of the present invention; and
Figure 3 illustrates a transmitter according to another embodiment of the present invention.

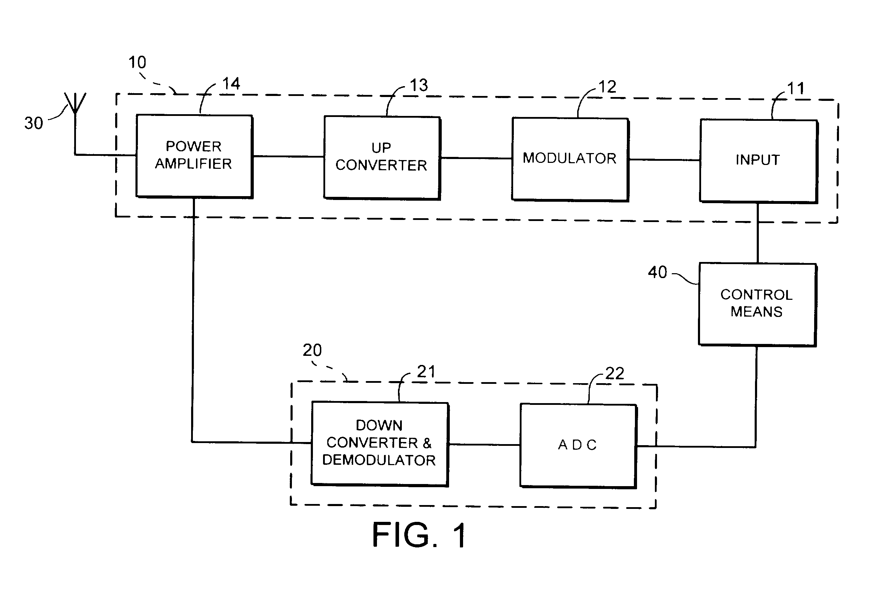

Figure 1 is a block diagram of a transmitter in accordance with a preferred embodiment of the present invention, for providing adaptive predistortion. The transmitter comprises a conventional transmission path indicated generally as 10, and a feedback path 20 for feeding back the signal at the output of the transmission path for comparison with the signal at the transmitter input. It also comprises control means 40 for controlling the input to the transmission path based on the comparison of the signals.

The transmission path comprises an input 11 for receiving the signal to be transmitted, and demodulator 12 for modulating that signal with a carrier or modulating signal to obtain a modulated signal. An up-converter 13 is also provided in the transmission path to up-convert the modulated signal from a baseband frequency to a frequency suitable for radio transmission (e.g. UHF), together with a power amplifier 14 for amplifying the resultant up-converted signal. The power amplifier output is coupled to both an antenna 30 for transmitting the signal, and the transmitter's feedback path 20.

The feedback path 20 comprises a down-converter and demodulator 21 for converting the signal back to a baseband frequency and demodulating it to obtain a demodulated signal. The feedback path 20 also comprises an analog to digital converter 22 for converting the demodulated signal into a digital signal.

Control means 40 is provided to determine whether distortion of the signal has resulted by analysing the digital signal output by the A/D converter. If distortion has occurred, the control means determines the amount of compensation required to minimise the distortion, and adjusts the signal to be input to the transmitter input 11 accordingly. The control means 40 may, for example, comprise a digital signal processor (DSP). The DSP may compare the signal input to the transmitter input 11 with the signal output by the A/D converter 22 to determine the error function introduced by the power amplifier (and other components). The amount of compensation required to take the error function into account may be ascertained by way of a look-up table in the DSP, and the DSP may consequently apply the level required to the next signal to be transmitted prior to its input to the transmitter input 11.

An error function of particular interest is non-linearity introduced by the power amplifier 14. Non-linear power amplifiers have improved efficiency over linear power amplifiers, and thus have the advantage of improved power efficiency. This is of continuing importance in the field of portable electronic devices, such as radio telecommunication devices. However, non-linear power amplifiers are incompatible with certain telecommunication systems (particularly those which use amplitude modulation), as the non-linear power amplifiers cause spurious components to be transmitted out of the required band by the transmitter, thus causing unacceptable interference within the system. The present invention provides a transmitter which adaptively compensates for power amplifier non-linearities, and thus enables a non-linear power amplifier to be used in systems where it would ordinarily be prohibited.

The down-converter and demodulator 21 and the A/D converter 22 may be dedicated components of the transmitter feedback path 20. However, when implemented in a transceiver, they are preferably parts of the receiver circuitry, as this reduces the number of components and thus size and cost of the device.

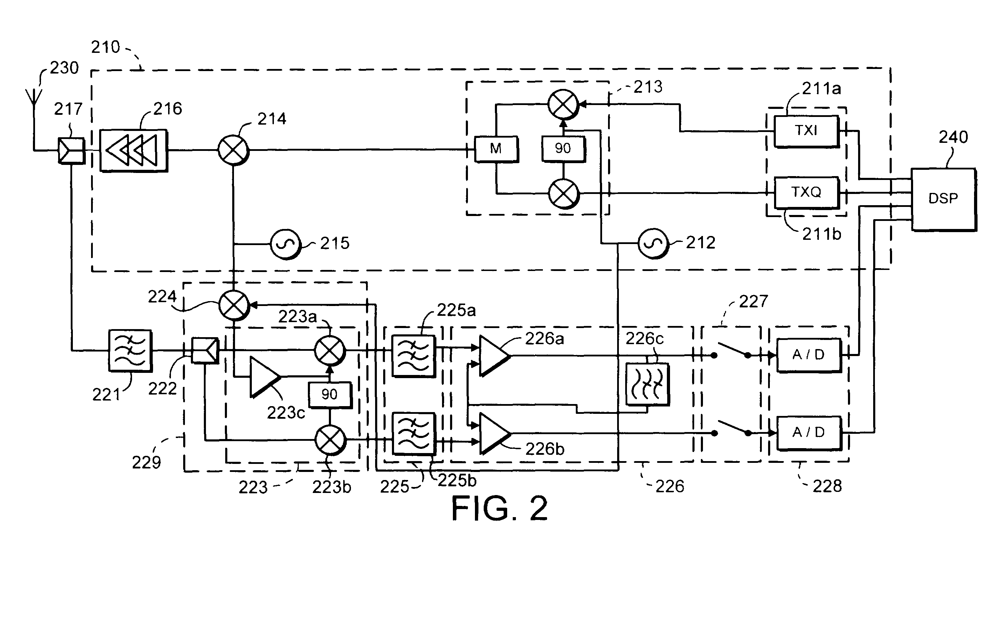

Figure 2 illustrates a transmitter for use in a radio telephone, in this embodiment operating in a telecommunications system using IQ modulation.

The transmission path 210 comprises transmitter input means 211, a modulator 213, a mixer 214, a power amplifier 216, and two voltage controlled oscillators (VCO), one providing a signal of carrier frequency (VHF VCO 212) and the other providing a signal of up-converting frequency (UHF VCO 215).

The transmitter input means comprises an I signal input 211 a and a Q signal input 211b. The modulator comprises two mixers, one for modulating the I signal and one for modulating the Q signal and a summer. The inputs 211 a, 211b are under the control of a control means, DSP 240, and forward the I and Q signals to respective mixer inputs. The modulating signal from VHF VCO 212 is input in phase to the I mixer and is quadrature phase shifted by the modulator 213 for input to the Q mixer. The resultant signals are summed to obtain the resultant modulated signal. The modulated signal is up-converted by the mixer 24, which mixes it with signal of up-converting frequency from the UHF VCO 215. The resultant signal of up-converted frequency is fed into the power amplifier 216 which amplifies the signal for transmission. A beam splitter 217 splits the signal output by the power amplifier, so that it is transmitted via an antenna 230 and also fed into the transmitter's feedback path.

The feedback path comprises lowpass filters 221 and 225, a direct down-converter and demodulator 229, a DC offset compensator 226, switching means 227 and A/D converter means 228. The lowpass filter 221 is provided to eliminate the spurious components caused by harmonics. That is, it provides spectral shaping.

The direct down-converter and demodulator 229 comprises a beam splitter 222, a demodulator 223 and a mixer 224. The demodulator comprises two mixers 223a and 223b, one for demodulating the I signal (223a) and one for demodulating the Q signal (223b) and an amplifier 223c. The beam splitter forwards the transmitted signal to an input of each of the mixers 223a and 223b. The mixer 224 provides a down-converting demodulating signal (LO) by mixing the up-converting frequency signal from UHF VCO 215 with the modulating frequency signal from UHF VCO 212. The low signal is amplified by the amplifier 223c, is input in phase with the I mixer 223a and is quadrature phase shifted by the demodulator 223 for input to the Q mixer 223b. The lowpass filter means 225 comprises two lowpass filters, 225a and 225b for dealing with the harmonics caused by the respective mixers 223a and 223b. The output of these filters are input into the DC offset compensator 226.

A DC offset compensator 226 may be required when direct down-conversion is employed. Associated problems with direct down-conversion include error vectors (caused by second order intermodulation) and adjacent channel interference. If necessary, these can be overcome by the provision of a DC offset compensator, such as the simple one employed in this embodiment. The DC offset compensator also ensures that the input signal is within the dynamic range of A/D converters.

The DC compensator 226 comprises 2 operational amplifiers 226a, 226b and a lowpass filter 226c. The lowpass filter 226c is in the feedback path from the output of the operational amplifier 226a to the input of both operational amplifiers 226a and b. The other input of the operational amplifiers 226a and 226b are coupled to the filter outputs for receiving the demodulated filtered I and Q signals respectively. As the lowpass filter is in the feedback path, it in effect acts as a highpass filter, only allowing signals of frequency higher than its threshold to be output, thereby eliminating DC offset.

The DC offset compensation circuit 226 of this embodiment takes a finite time to track out the DC component, and is hence not generally considered applicable in receiver type applications. However, it can be used in the present situation since the power amplifier characteristics do not change quickly, and even if a few symbols were to be lost at the start of the burst, enough symbols would remain upon which to apply adaptive compensation.

The DC compensator 226 is coupled to A/D converter means 228 via switching means 227. The switching means 227 open and close the feedback path to determine when adaptive predistortion is to be employed. Periodic sampling is sufficient (e.g. 1/200 cycles), again due to the slow change of the power amplifier characteristics, and is advantageous in that it reduces the power consumption due to the distortion detection circuitry. Preferably, the switching means 227 controls operation of the A/D converter means 228, as A/D converters are power hungry components.

The DSP 240 determines the error function introduced by the power amplifier, and adjusts the level of input signal to the transmission path accordingly.

The modification of current transceiver designs to provide adaptive predistortion is minimal, and only results in a slight increase in size of the device. One reason that only a small increase in size occurs is due to the simplicity of the architecture, and another is the re-use of components already present in the transmitter and receiver paths. For example, the transmitter VCOs 212 and 215 are re-used as inputs to the mixer 224 to provide the demodulating and down-converting signals. The extent to which receiver components in particular can be used depends upon the system in which the device is to be used. Generally, a common spectral shaping filter 221 and common A/D converters can be used for the receiver and transmitter feedback paths. On the other hand, not all systems currently facilitate the use of direct down conversion. Japan's Personal Digital Cellular System (PDC) is one such system, due to its narrow band nature. In this case, either direct down conversion and demodulation means 229 is provided in the feedback path in addition to the mixer and demodulator stages in the receiver path, or preferably both the receiver and feedback paths use a common demodulator 223.

Other systems which are compatible with direct down conversion, e.g. GSM, Wideband CDMA, may use common down converting and demodulating means 229 as part of the predistortion circuitry and receiver circuitry.

Whatever the case, the additional circuitry required for adaptive predistortion may mainly be implemented in silicon. In the embodiment of Figure 2, only the filters need be provided by way of components on a PCB. Moreover, filters 225a and 225b can be eliminated if required, and instead the filtering can be provided by the DSP.

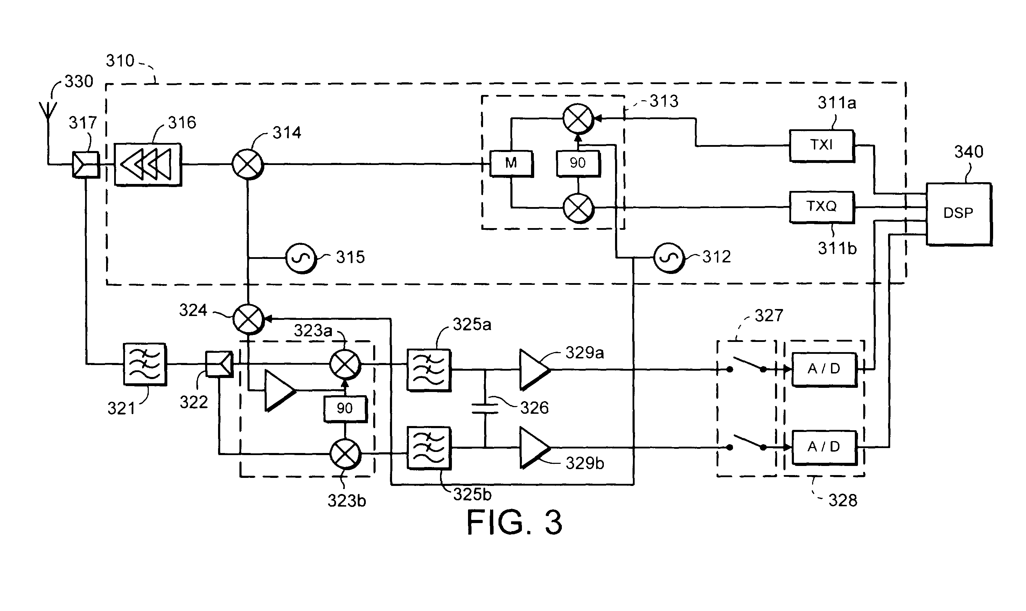

Figure 3 illustrates a transmitter according to another embodiment of the present invention. This transmitter has an alternative DC offset compensator to that shown in Figure 2. The other components are the same, and thus will not be described again. In this embodiment, the circuitry 226 of Figure 2 has been replaced by AC coupling. The AC coupling has been effected by the provision of a capacitor 326 across the I and Q paths of the feedback path. The circuit also comprises amplifiers 329a, 329b, one on each of the I and Q paths to amplify the signal prior to its input to the A/D converter 328. These amplifiers are preferably common to the receiver circuitry. As will be appreciated this alternative may require extra processing by the DSP 340, depending on the requirements of the system. However, it is a cheaper and smaller alternative since no additional operational amplifiers are required in silicon, nor is resistor required on the PCB to make up the lowpass filter 226c. This embodiment lends itself particularly to wideband systems such as Wideband CDMA.

The present invention provides a transmitter architecture enabling accurate feedback of phase and amplitude information from the power amplifier output to a control means (DSP) where adaptive predistortion is performed to linearise high efficiency non-linear power amplifiers using a cheap and feasible feedback path. That is, the invention provides a cheap and practical implementation for providing the receive path back to the digital domain, where algorithms for adaptive predistortion may be applied. The fact that the input power to this path will be high (since it can be split at a reasonable level from the power amplifier output) has been utilised. In addition to this, since the signal has not been through any external propagation environment, there will be no effects from interference or multi-path propagation to combat. Hence, a relatively crude receiver design is able to be implemented for the feedback path, as opposed to using to a conventional receiver, thus reducing costs significantly. The circuits shown in the embodiments of Figures 2 and 3 require only one or two external components, since most changes can be undertaken in silicone at little extra expense.

The present invention is particularly advantageous in devices for use in telecommunication systems which use amplitude modulation schemes ( for example CDMA and PDC) as it enables a non-linear power amplifier to be used which thus improves the efficiency over the use of a conventional device using a linear power amplifier.

Furthermore, the invention is also useful in telecommunication systems which use modulation schemes providing theoretically constant amplitude (e.g. GSM). In such cases, the adaptive predistortion may compensate for distortion by the power amplifier which in practice causes a variation in amplitude envelope. In addition, it enables the use of a lower specification power amplifier (e.g. one with larger tolerances) than conventional to achieve a desired efficiency.

The present invention includes any novel feature or combination of features disclosed herein either explicitly or any generalisation thereof irrespective of whether or not it relates to the claimed invention or mitigates any or all of the problems addressed.

In view of the foregoing description it will be evident to a person skilled in the art that various modifications may be made within the scope of the invention.

## Claims

1. A transmitter for a radiotelephone, comprising:
a power amplifier in its transmission path for amplifying a signal to be transmitted;
a feedback path from the power amplifier output to the transmission path input;
a demodulator for down-converting and demodulating the signal output by the power amplifier in the feedback path; and
means for adjusting the signal to be applied to the transmitter input in response to the demodulator output.

2. A transmitter as claimed in claim 1, wherein the demodulator comprises a mixer having an input coupled to an up-converting frequency source, an input coupled to a modulating source and an output for providing the demodulating signal.

3. A transmitter as claimed in claim 2, wherein the mixer inputs are coupled to the transmitter's up-converting frequency source and modulating source.

4. A transmitter as claimed in any preceding claim, wherein the demodulator comprises a DC offset compensator.

5. A transmitter as claimed in claim 4, wherein the DC offset compensator comprises an integrator.

6. A transmitter as claimed in claim 4, wherein the DC offset compensator comprises an operational amplifier having a feedback path from its output to its negative input and a low pass filter in the operational amplifier's feedback path.

7. A transmitter as claimed in claim 5, wherein the demodulator comprises an IQ demodulator and the DC offset compensator has an operational amplifier associated with each IQ demodulator output.

8. A transmitter as claimed in any preceding claim, wherein the demodulator comprises means for periodically presenting a demodulated signal to the adjusting means.

9. A transmitter as claimed in claim 8, wherein the means for periodically presenting a demodulated signal to the adjusting means comprises switching means for opening and closing the transmitter feedback path.

10. A transmitter as claimed in any preceding claim, wherein the demodulator comprises analogue to digital converter means for converting a demodulated signal into a corresponding digital signal.

11. A transmitter as claimed in claim 10, when dependent upon claim 9, wherein the switching means operates the analogue to digital converter means.

12. A transceiver comprising a transmitter as claimed in any preceding claim and a receiver.

13. A transceiver as claimed in claim 12, wherein the transmitter feedback path is provided by receiver circuitry.

14. A transmitter substantially as hereinbefore described, with reference to, and/or as illustrated in any of the figures of the accompanying drawings.

15. A transceiver substantially as hereinbefore described, with reference to, and/or as illustrated in any of the figures of the accompanying drawings.
